# EUROPEAN PATENT APPLICATION

(11) **EP 3 410 823 A1**
(43) Date of publication of application: **05.12.2018**
(21) Application number: 16888184.5
(22) Date of filing: 16.12.2016
(51) Int. Cl.: H05B 33/04, H01L 51/50, H05B 33/26

(54) **LIGHT-EMITTING DEVICE**

(30) Priority: 26.01.2016 JP 2016012544
(71) Applicant: Sumitomo Chemical Company, Limited, Tokyo 104-8260 (JP)
(72) Inventor: MIMA Shoji, Niihama-shi Ehime 792-0015 (JP)
(74) Representative: J A Kemp
(86) International application number: PCT/JP2016/087560
(87) International publication number: WO 2017/130600

(57) **Abstract**

A light emitting device (1) includes a support substrate (3), an organic EL element (10) disposed on the support substrate (3), and a sealing member (11) that seals the organic EL element (10) and has a space (S) in which the organic EL element (10) is accommodated, and an inert gas is contained in the space (S). The organic EL element (10) is formed by laminating a first electrode layer (5), an organic functional layer (7) and a second electrode layer (9) on the support substrate (3) in that order. In the sealing member (11), a desiccant (15) is provided at a position facing the second electrode layer (9). The second electrode layer (9) includes at least three metal layers. Among the plurality of metal layers, one metal layer is made of aluminum and the uppermost metal layer is made of silver.

## Description

### Technical Field

The present invention relates to a light emitting device.

### Background Art

As a conventional light emitting device, for example, a device described in Patent Literature 1 is known. The light emitting device described in Patent Literature 1 includes a support substrate, a light emitting unit that is formed on the support substrate and includes a first electrode, a second electrode that overlaps the first electrode, and an organic layer that is positioned between the first electrode and the second electrode, and a sealing member that seals the light emitting unit. In the light emitting device, in the sealing member, a desiccant (hygroscopic material) is provided at a position facing the second electrode of the light emitting unit.

### Citation List

### Patent Literature

[Patent Literature 1] Japanese Patent Application Laid-Open Publication No. 2015-162444

### Summary of Invention

### Technical Problem

As in the above light emitting device, in a configuration in which a desiccant is provided at a position facing the second electrode, light emission unevenness may locally occur in a part in which the light emitting unit and the desiccant overlap in a plan view. As a result of examining the unevenness, the inventors found that a degassing component generated from the desiccant and a metal constituting the second electrode react and unevenness is generated. The unevenness deteriorates the light emission quality of the light emitting unit.

An object of an aspect of the present invention is to provide a light emitting device capable of improving light emission quality.

### Solution to Problem

A light emitting device according to an aspect of the present invention includes a support substrate, an organic EL element disposed on the support substrate, and a sealing member that seals the organic EL element and has a space in which the organic EL element is accommodated, and an inert gas is contained in the space. The organic EL element is formed by laminating a first electrode layer, an organic functional layer and a second electrode layer on the support substrate in that order, in the sealing member, a desiccant is provided at a position facing the second electrode layer, the second electrode layer includes at least three metal layers, and among the plurality of metal layers, at least one of the metal layers is made of aluminum and the uppermost metal layer is made of silver.

In the light emitting device according to the aspect of the present invention, in the sealing member, a desiccant is provided at a position facing the second electrode layer. In this configuration, the uppermost layer of the second electrode layer is made of silver. The inventors conducted extensive studies and as a result, found that, when a second electrode layer disposed at a position facing the desiccant is composed of a plurality of metal layers, and the uppermost layer of the second electrode layer is made of silver, it is possible to reduce a reaction with a degassing component generated from the desiccant. Thereby, in the light emitting device, it is possible to reduce the occurrence of unevenness in the light emitting unit. As a result, it is possible to improve light emission quality in the light emitting device.

In one embodiment, in the second electrode layer, a first metal layer made of aluminum, a second metal layer made of silver, a third metal layer made of aluminum, and a fourth metal layer made of silver may be laminated on the organic functional layer in that order. In such a configuration, it is possible to further reduce the occurrence of unevenness in the light emitting unit.

In one embodiment, the desiccant may contain at least one selected from the group consisting of polytetrafluoroethylene, calcium oxide, and carbon. When this desiccant is used, a configuration of the second electrode layer having the above structure is particularly effective in reducing the occurrence of unevenness in the light emitting unit.

In one embodiment, the desiccant may be attached to the sealing member via an adhesive part, and the adhesive part may contain an acrylic acid ester copolymer. There is a possibility of a degassing component being generated from the adhesive part over time. In the cathode layer, since the uppermost layer is made of silver, it is possible to reduce a reaction with a degassing component generated from the adhesive part containing an acrylic acid ester copolymer. Thus, it is possible to reduce the occurrence of unevenness due to a degassing component of the adhesive part.

### Advantageous Effects of Invention

According to an aspect of the present invention, it is possible to improve light emission quality.

### Brief Description of Drawings

FIG. 1 is a cross-sectional view of a light emitting device according to one embodiment.
FIG. 2 is a cross-sectional view showing a cathode layer.

### Description of Embodiments

Exemplary embodiments of the present invention will be described below in detail with reference to the appended drawings. Here, the same or corresponding components are denoted with the same reference numerals in the following description, and redundant descriptions thereof will be omitted.

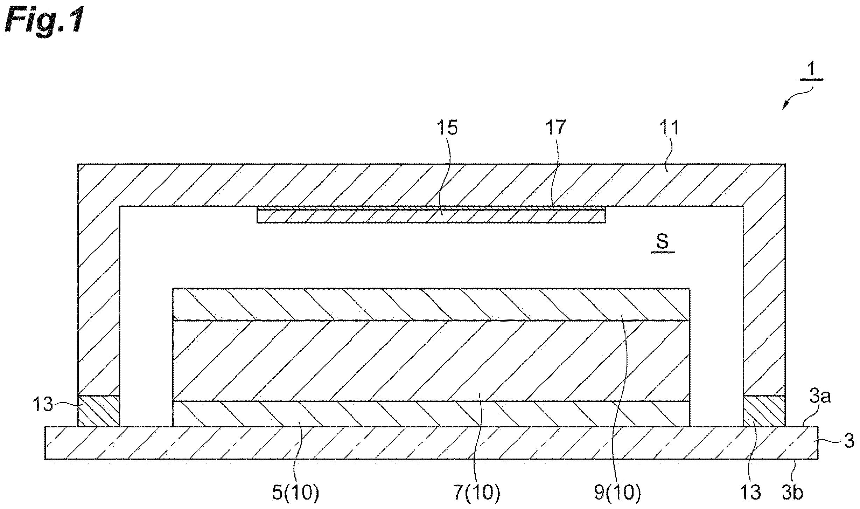

As shown in FIG. 1, a light emitting device 1 includes a support substrate 3, an organic EL element 10, and a sealing member 11. The organic EL element 10 includes an anode layer (first electrode layer) 5, an organic functional layer 7, and a cathode layer (second electrode layer) 9.

### [Support substrate]

The support substrate 3 is made of glass or a resin that transmits visible light (light with a wavelength of 400 nm to 800 nm). When resin materials are selected for the support substrate 3, for example, polyethersulfone (PES); a polyester resin such as polyethylene terephthalate (PET), and polyethylene naphthalate (PEN); a polyolefin resin such as polyethylene (PE), polypropylene (PP), and a cyclic polyolefin; a polyamide resin; a polycarbonate resin; a polystyrene resin; a polyvinyl alcohol resin; a saponified ethylene-vinyl acetate copolymer product; a polyacrylonitrile resin; an acetal resin; a polyimide resin; or an epoxy resin can be used.

As a material of the support substrate 3, among the above resins, a polyester resin and a polyolefin resin are preferable and polyethylene terephthalate and polyethylene naphthalate are particularly preferable because they have high heat resistance, a low coefficient of linear expansion, and low production costs. In addition, one of these resins may be used alone or two or more thereof may be used in combination.

A water barrier layer (barrier layer) may be disposed on one main surface 3a of the support substrate 3. The other main surface 3b of the support substrate 3 is a light emitting surface.

### [Anode layer]

The anode layer 5 is disposed on one main surface 3a of the support substrate 3. As the anode layer 5, an electrode layer exhibiting light transmittance is used. As an electrode (layer) exhibiting light transmittance, a thin film of a metal oxide, a metal sulfide or a metal having high electrical conductivity can be used and a thin film having high light transmittance is suitably used. For example, thin films made of indium oxide, zinc oxide, tin oxide, indium tin oxide (abbreviation ITO), indium zinc oxide (abbreviation IZO), gold, platinum, silver, copper, and the like may be used, and a thin film made of ITO, IZO, or tin oxide among them is suitably used.

As the anode layer 5, a transparent conductive film of an organic substance such as polyaniline and derivatives thereof, and polythiophene and derivatives thereof may be used. In addition, as the anode layer 5, an electrode in which a metal, a metal alloy, or the like is patterned in a mesh form or an electrode in which nanowires containing silver are formed in a network form may be used.

The thickness of the anode layer 5 can be determined in consideration of light transmittance, electrical conductivity, and the like. The thickness of the anode layer 5 is generally, 10 nm to 10 µm, preferably 20 nm to 1 µm, and more preferably 50 nm to 500 nm.

Examples of a method of forming the anode layer 5 include a vacuum deposition method, a sputtering method, an ion plating method, a plating method, and a coating method.

### [Organic functional layer]

The organic functional layer 7 is disposed on the anode layer 5. The organic functional layer 7 includes a light emitting layer. Generally, the organic functional layer 7 includes an organic substance that mainly emits fluorescence and/or phosphorescence or an organic substance and a dopant material for a light emitting layer that assists the organic substance. The dopant material for a light emitting layer is added, for example, in order to improve luminous efficiency and change a light emission wavelength. Here, the organic substance may be a low-molecular-weight compound or a high-molecular-weight compound. Examples of a light emitting material constituting the organic functional layer 7 include the following dye materials, metal complex materials, polymer materials, and dopant materials for a light emitting layer.

### (Dye material)

Examples of the dye material include cyclopentamine and derivatives thereof, tetraphenyl butadiene and derivatives thereof, triphenylamine and derivatives thereof, oxadiazole and derivatives thereof, pyrazoloquinoline and derivatives thereof, distyrylbenzene and derivatives thereof, distyrylarylenes and derivatives thereof, pyrrole and derivatives thereof, thiophene compounds, pyridine compounds, perinone and derivatives thereof, perylene and derivatives thereof, oligothiophenes and derivatives thereof, oxadiazole dimers and derivatives thereof, pyrazoline dimers and derivatives thereof, quinacridone and derivatives thereof, and coumarin and derivatives thereof.

### (Metal complex material)

Examples of the metal complex material include metal complexes including a rare earth metal such as Tb, Eu, and Dy or Al, Zn, Be, Pt, Ir, or the like as a central metal and having an oxadiazole, thiadiazole, phenylpyridine, phenylbenzimidazol, or quinoline structure as a ligand. Examples of the metal complex include a metal complex having luminescence in a triplet excited state of an iridium complex, a platinum complex, or the like, an aluminum quinolinol complex, a benzoquinolinol beryllium complex, a benzoxazolyl zinc complex, a benzothiazole zinc complex, an azomethyl zinc complex, a porphyrin zinc complex, and a phenanthroline europium complex.

### (Polymer material)

Examples of the polymer material include polyparaphenylene vinylene and derivatives thereof, polythiophene and derivatives thereof, polyparaphenylene and derivatives thereof, polysilane and derivatives thereof, polyacetylene and derivatives thereof, polyfluorene and derivatives thereof, polyvinylcarbazole and derivatives thereof, a dye material, and a material obtained by polymerizing metal complex materials.

### (Dopant material for a light emitting layer)

Examples of the dopant material for a light emitting layer include perylene and derivatives thereof, coumarin and derivatives thereof, rubrene and derivatives thereof, quinacridone and derivatives thereof, squarylium and derivatives thereof, porphyrin and derivatives thereof, styryl dyes, tetracene and derivatives thereof, pyrazolone and derivatives thereof, decacyclene and derivatives thereof, and phenoxazone and derivatives thereof.

The thickness of the organic functional layer 7 is generally about 2 nm to 200 nm. For example, the organic functional layer 7 is formed by a coating method using a coating solution (for example, an ink) containing the light emitting material described above. A solvent of a coating solution containing the light emitting material is not limited as long as it dissolves the light emitting material.

### [Cathode layer]

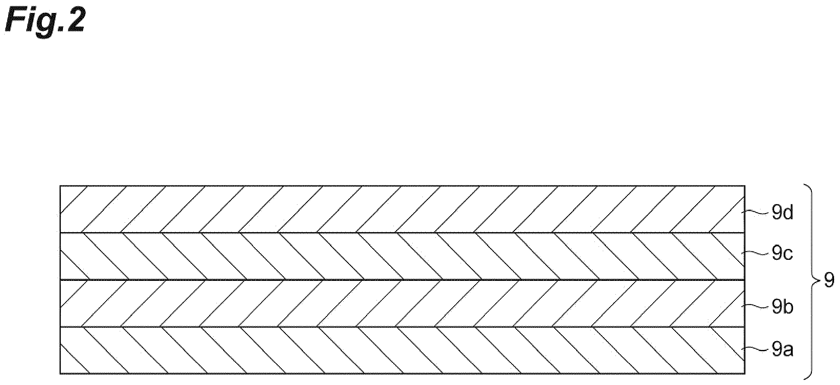

The cathode layer 9 is disposed on the organic functional layer 7. As shown in FIG. 2, the cathode layer 9 includes a first cathode layer (first metal layer) 9a, a second cathode layer (second metal layer) 9b, a third cathode layer (third metal layer) 9c, and a fourth cathode layer (fourth metal layer) 9d. The first cathode layer 9a is made of aluminum. The second cathode layer 9b is made of silver. The third cathode layer 9c is made of aluminum. The fourth cathode layer 9d is made of silver.

The thickness of the cathode layer 9 is generally 10 nm to 10 µm, and preferably 100 nm to 1 µm. In the present embodiment, the thickness of the cathode layer 9 is 700 nm. Specifically, the thickness of the first cathode layer 9a is, for example, 200 nm. The thickness of the second cathode layer 9b is, for example, 100 nm. The thickness of the third cathode layer 9c is, for example, 300 nm. The fourth cathode layer 9d is made of silver. The thickness of the fourth cathode layer 9d is, for example, 100 nm.

In the cathode layer 9, the first cathode layer 9a, the second cathode layer 9b, the third cathode layer 9c, and the fourth cathode layer 9d are laminated in that order. The first cathode layer 9a is the lowermost layer of the cathode layer 9. That is, the first cathode layer 9a is disposed on the organic functional layer 7. The fourth cathode layer 9d is the uppermost layer of the cathode layer 9. That is, the fourth cathode layer 9d faces the sealing member 11.

Examples of a method of forming the cathode layer 9 include a vacuum deposition method, a sputtering method, a lamination method of thermocompression-bonding a metal thin film, and a coating method.

### [Sealing member]

The sealing member 11 seals the organic EL element 10. The sealing member 11 is a box-shaped member. As a material of the sealing member 11, for example, glass, a metal selected from among aluminum, copper, and iron, and an alloy containing at least one among such metals can be used. The sealing member 11 is disposed so that it covers the organic EL element 10 disposed on the support substrate 3. The sealing member 11 is disposed on the support substrate 3 and forms a space S in which the organic EL element 10 is accommodated. An inert gas is contained in the space S. The inert gas is, for example, nitrogen gas.

The sealing member 11 is adhered to the support substrate 3 by an adhesive part 13. The adhesive part 13 is disposed in a frame form, and adheres the support substrate 3 to the sealing member 11. Thereby, the organic EL element 10 is sealed and protected from oxygen in the atmosphere and water. For example, the adhesive part 13 is made of a transparent material such as an ultraviolet curable resin, a thermosetting resin, an ultraviolet delayed curable resin, and a 2-liquid mixture curable resin which is formed of an epoxy resin or other resins.

A desiccant 15 is provided inside the sealing member 11. Specifically, the desiccant 15 is disposed on an inner surface (ceiling surface) of the sealing member 11 that faces the cathode layer 9. In the present embodiment, the desiccant 15 has a sheet form. In the present embodiment, the desiccant 15 contains polytetrafluoroethylene, calcium oxide, and carbon. A plurality of desiccants 15 may be provided in the sealing member 11. The desiccant 15 is attached to the sealing member 11 via an adhesive layer (adhesive part) 17. The adhesive layer 17 contains an acrylic acid ester copolymer.

As described above, in the light emitting device 1 according to the present embodiment, in the sealing member 11, the desiccant 15 is provided at a position facing the cathode layer 9. In this configuration, the fourth cathode layer 9d which is the uppermost layer of the cathode layer 9 is made of silver. Thereby, in the light emitting device 1, it is possible to reduce a reaction between a degassing component of the desiccant 15 and the cathode layer 9. Therefore, in the light emitting device 1, it is possible to reduce the occurrence of unevenness in a light emitting unit (the cathode layer 9). As a result, in the light emitting device 1, it is possible to improve light emission quality.

In the present embodiment, in the cathode layer 9, on the organic functional layer 7, the first cathode layer 9a made of aluminum, the second cathode layer 9b made of silver, the third cathode layer 9c made of aluminum, and the fourth cathode layer 9d made of silver are laminated in that order. In such a configuration,_it is possible to further reduce the occurrence of the light emitting unit.

Here, a dark spot (non-light emitting point) is generated in a defective part of the cathode layer 9, and unevenness (hereinafter referred to as "haze unevenness") in which a plurality of fine dark spots are collected is generated. In the present embodiment, the total thickness of the cathode layer 9 is 700 nm. In addition, in the cathode layer 9, the first cathode layer 9a and the third cathode layer 9c which are made of aluminum, and the second cathode layer 9b and the fourth cathode layer 9d which are made of silver are alternately formed. In this manner, when metal layers made of different materials are alternately formed, and thus the cathode layer 9 is formed by, for example, a deposition method, since the ordering of the layers has variation, the rigidity of the cathode layer 9 can be secured. Therefore, it is possible to reduce the occurrence of cracks (breakages) in the cathode layer 9 due to foreign matter and the occurrence of structural defects in the cathode layer 9. As a result, since it is possible to reduce the occurrence of dark spots, it is possible to reduce the occurrence of haze unevenness. In particular, when the total thickness of the cathode layer 9 is set to 500 nm or more, it is possible to effectively reduce the occurrence of dark spots in the cathode layer 9.

In the present embodiment, the desiccant 15 contains polytetrafluoroethylene, calcium oxide, and carbon. When the desiccant 15 is used, a configuration of the cathode layer 9 having the above structure is particularly effective in reducing the occurrence of unevenness in the light emitting unit.

In the present embodiment, the desiccant 15 is attached to the sealing member 11 via the adhesive layer 17. In the present embodiment, the adhesive layer 17 contains an acrylic acid ester copolymer. There is a possibility of a degassing component being degenerated from the adhesive layer 17 over time. Since the cathode layer 9 serves as the fourth cathode layer 9d that is the uppermost layer, it is possible to reduce a reaction with a degassing component generated from the adhesive layer 17 containing an acrylic acid ester copolymer. Thus, it is possible to reduce the occurrence of unevenness due to the degassing component of the desiccant 15.

### [Examples]

The present invention will be described below in further detail with reference to examples and comparative examples. However, the present invention is not limited to the following examples.

[Example 1] As Example 1, a light emitting device including an organic EL element in which an anode layer, an organic functional layer, a cathode layer and a sealing layer were laminated on a support substrate in that order was produced.

As the support substrate, alkali-free glass with a thickness of 0.5 mm was prepared. On the support substrate, the anode layer and the organic functional layer were formed. As the organic functional layer, a hole injection layer, a hole transport layer, a light emitting layer, and an electron injection layer were formed.

As the cathode layer, four layers of aluminum/silver/aluminum/silver were formed by a vacuum deposition method. The thickness of the cathode layer was 700 nm. Specifically, the thickness of the first aluminum layer (the lowermost layer) was 200 nm. The thickness of the second silver layer was 100 nm. The thickness of the third aluminum layer was 300 nm. The thickness of the fourth silver layer (the uppermost layer) was 100 nm.

After the cathode layer was formed, the organic EL element was sealed by a sealing member, and a desiccant was provided on a ceiling surface of the sealing member. A desiccant containing polytetrafluoroethylene, calcium oxide, and carbon was used. The desiccant was attached to the sealing member via the adhesive layer. An adhesive layer containing an acrylic acid ester copolymer was used. Thereby, the light emitting device of Example 1 was obtained.

The light emitting device of Example 1 was left in a temperature of 85 °C and a humidity (RH) of 90% environment, and it was checked whether haze unevenness occurred after 4 days and whether unevenness occurred due to a desiccant during initial light emission (initial). The found results are shown in Table 1. In Table 1, "X" indicates that unevenness occurred, and "O" indicates that no unevenness occurred. Here, when it is shown that unevenness occurred, this means that unevenness occurred to an extent that they affected light emission quality.

**[Table 1]**

| | Occurrence of haze unevenness | Occurrence of unevenness due to desiccant |
|---|---|---|
| Example 1 | ○ | ○ |
| Comparative Example 1 | X | ○ |
| Comparative Example 2 | ○ | X |

As shown in Table 1, in the light emitting device of Example 1, the occurrence of haze unevenness and the occurrence of unevenness due to a desiccant were not found. Haze unevenness was not found even after 10 days.

### [Comparative Example 1]

In Comparative Example 1, a light emitting device was obtained in the same production method as in Example 1 except that a cathode layer was composed of two layers which were aluminum/silver. The thickness of the cathode layer was 300 nm. Specifically, the thickness of the first aluminum layer (the lowermost layer) was 200 nm. The thickness of the second silver layer (the uppermost layer) was 100 nm. In the light emitting device of Comparative Example 1, since the uppermost layer of the cathode layer was made of silver, the occurrence of unevenness due to a desiccant during initial light emission was not found. Haze unevenness was found after 4 days.

### [Comparative Example 2]

In Comparative Example 2, a light emitting device was obtained in the same production method as in Example 1 except that a cathode layer was composed of three layers which were aluminum/silver/aluminum. The thickness of the cathode layer was 600 nm. Specifically, the thickness of the first aluminum layer (the lowermost layer) was 200 nm. The thickness of the second silver layer was 100 nm. The thickness of the third aluminum layer (the uppermost layer) was 300 nm. In the light emitting device of Comparative Example 2, since the uppermost layer of the cathode layer was made of aluminum, unevenness due to a desiccant during initial light emission was found. No haze unevenness was found even after 4 days because the thickness of the cathode layer was formed to be relatively high.

Here, the present invention is not limited to the present embodiment described above, and various modifications can be made. For example, in the above embodiment, the organic EL element 10 in which the organic functional layer 7 including a light emitting layer is disposed between the anode layer 5 and the cathode layer 9 is shown. However, the configuration of the organic functional layer 7 is not limited thereto. The organic functional layer 7 may have the following configurations.
(a) (Anode layer)/light emitting layer/(cathode layer)
(b) (Anode layer)/hole injection layer/light emitting layer/(cathode layer)
(c) (Anode layer)/hole injection layer/light emitting layer/electron injection layer/(cathode layer)
(d) (Anode layer)/hole injection layer/light emitting layer/electron transport layer/electron injection layer/(cathode layer)
(e) (Anode layer)/hole injection layer/hole transport layer/light emitting layer/(cathode layer)
(f) (Anode layer)/hole injection layer/hole transport layer/light emitting layer/electron injection layer/(cathode layer)
(g) (Anode layer)/hole injection layer/hole transport layer/light emitting layer/electron transport layer/electron injection layer/(cathode layer)
(h) (Anode layer)/light emitting layer/electron injection layer/(cathode layer)
(i) (Anode layer)/light emitting layer/electron transport layer/electron injection layer/(cathode layer)
   Here, the symbol "/" indicates that layers between which the symbol "/" is interposed are laminated adjacent to each other. The configuration of (a) is a configuration of the organic EL element 10 in the above embodiment.
   As materials of the hole injection layer, the hole transport layer, the electron transport layer and the electron injection layer, known materials can be used. The hole injection layer, the hole transport layer, the electron transport layer and the electron injection layer can be formed by, for example, a coating method in the same manner as in the organic functional layer 7.
   The organic EL element 10 may include a single organic functional layer 7 or two or more organic functional layers 7. In any one of the layered configurations of (a) to (i), when a lamination structure disposed between the anode layer 5 and the cathode layer 9 is set as a "structural unit A," as a configuration of an organic EL element including two organic functional layers 7, for example, a layered configuration shown in the following (j), can be exemplified. Two layered configurations (structural units A) may be the same or different from each other.
(j) Anode layer/(structural unit A)/charge generation layer/(structural unit A)/cathode layer
   Here, the charge generation layer is a layer in which holes and electrons are generated when an electric field is applied. As the charge generation layer, a thin film made of, for example, vanadium oxide, ITO, or molybdenum oxide, can be exemplified.
   In addition, when "(structural unit A)/charge generation layer" is set as a "structural unit B," as a configuration of an organic EL element including three or more organic functional layers 7, for example, a layered configuration shown in the following (k), can be exemplified.
(k) Anode layer/(structural unit B)x/(structural unit A)/cathode layer

The symbol "x" represents an integer of 2 or more, and "(structural unit B)x" represents a laminate in which x (structural units B) are laminated. In addition, layered configurations of a plurality of (structural units B) may be the same or different from each other.

An organic EL element in which a plurality of organic functional layers 7 are directly laminated without providing a charge generation layer may be formed.

An example in which the cathode layer 9 is composed of four layers including the first cathode layer 9a, the second cathode layer 9b, the third cathode layer 9c, and the fourth cathode layer 9d has been described in the above embodiment. However, the cathode layer 9 may be composed of at least three metal layers. In the case of three layers, the cathode layer is preferably composed of silver/aluminum/silver layers.

### Reference Signs List

1 Light emitting device
3 Support substrate
5 Anode layer (first electrode layer)
7 Organic functional layer
9 Cathode layer (second electrode layer)
9a First cathode layer (first metal layer)
9b Second cathode layer (second metal layer)
9c Third cathode layer (third metal layer)
9d Fourth cathode layer (fourth metal layer)
10 Organic EL element
11 Sealing member
15 Desiccant
17 Adhesive layer (adhesive part)
S Space

## Claims

1. A light emitting device including a support substrate, an organic EL element disposed on the support substrate, and a sealing member that seals the organic EL element and has a space in which the organic EL element is accommodated, and an inert gas is contained in the space,
wherein the organic EL element is formed by laminating a first electrode layer, an organic functional layer and a second electrode layer on the support substrate in that order,
in the sealing member, a desiccant is provided at a position facing the second electrode layer,
the second electrode layer includes at least three metal layers, and
among the plurality of metal layers, at least one of the metal layers is made of aluminum and the uppermost metal layer is made of silver.

2. The light emitting device according to Claim 1 ,
wherein, in the second electrode layer, a first metal layer made of aluminum, a second metal layer made of silver, a third metal layer made of aluminum, and a fourth metal layer made of silver are laminated on the organic functional layer in that order.

3. The light emitting device according to Claim 1 or 2,
wherein the desiccant contains at least one selected from the group consisting of polytetrafluoroethylene, calcium oxide, and carbon.

4. The light emitting device according to any one of Claims 1 to 3,
wherein the desiccant is attached to the sealing member via an adhesive part, and
the adhesive part contains an acrylic acid ester copolymer.
